(19) Europäisches Patentamt
European Patent Office
Office européen des brevets

(11) **EP 2 658 116 A1**

(12) **EUROPEAN PATENT APPLICATION**

(43) Date of publication:
**30.10.2013 Bulletin 2013/44**

(51) Int Cl.:
*H03F 1/02* (2006.01)  *H03F 3/24* (2006.01)
*H03F 1/32* (2006.01)  *H03F 1/42* (2006.01)

(21) Application number: **12305465.2**

(22) Date of filing: **23.04.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Alcatel Lucent**
**75007 Paris (FR)**

(72) Inventors:
• **Yu, Xin**
**70435 Stuttgart (DE)**

• **Wong, James**
**London, W3 0HW (GB)**

(74) Representative: **2SPL Patentanwälte**
**Würmtalstrasse 119**
**81375 München (DE)**

Remarks:
Amended claims in accordance with Rule 137(2) EPC.

(54) **Amplifier circuit**

(57)  Embodiments relate to an amplifier circuit (200; 250), comprising a digital baseband processor (205) operable to decompose a digital baseband signal (102) having a useful signal bandwidth into a first signal part and into a second signal part, a first amplifier (115) operable to amplify a first radio frequency signal (212) corresponding to the first signal part, a second amplifier (120) operable to amplify a second radio frequency signal (214) corresponding to the second signal part, wherein the first and the second amplifiers (115; 120) are coupled to each other by means of at least one quarter-wavelength transformer (125) having a non-constant phase transfer function over the useful signal bandwidth, and wherein the digital baseband processor (205) is operable to process the second and/or the first signal part for at least partially pre-compensating the non-constant phase transfer function.

Fig. 2a

EP 2 658 116 A1

## Description

Embodiments of the present invention generally relate to wireless communications and, in particular, to power amplifiers for wireless communication systems.

Background

Wireless networks are steadily growing and more and more systems for mobile communication are deployed. For example, multiple generations of cellular networks have been developed and introduced to the mass markets. With the continuous extension and improvement of these wireless communication systems their inherent power consumption becomes more and more an issue. One of the major contributors to the power consumption of wireless communication systems are their base station transceivers, which are deployed to provide an almost 100% service coverage. The power consumption of a base station transceiver depends on several factors, where one major factor is the power consumption of the Power Amplifiers (PAs) used for transmission of the Radio Frequency (RF) signals, wherein a RF signal is a signal in a transmission frequency band, typically around a carrier frequency around several hundred MHz to several GHz. Power amplifiers are the most power consuming parts within a radio base station transceiver. Therefore the efficiency of the PA is critical to the overall power consumption of a base station transceiver and further to the power consumption of an entire wireless network. Thereby efficiency is a measure of how much of the source or supply power is usefully applied to the amplifier's output, i.e. radiated as RF power.

Legacy 2nd Generation (2G) or 2.5G mobile communication systems have made use of Frequency Division Multiple Access (FDMA) or Time Division Multiple Access (TDMA) schemes, where different user signals can be distinguished by their time and/or frequency characteristics in the transmission band. Instead, modem wireless communication networks, such as Wideband Code Division Multiple Access (WCDMA), Worldwide Interoperability for Microwave Access (WiMAX), and Long-Term Evolution (LTE), employ spectrum efficient Code Division Multiple Access (CDMA) or Orthogonal Frequency Division Multiple Access (OFDMA) modulation techniques that result in communication signals characterized by high amplitude variations, i.e. higher Peak-to-Average Power Ratios (PAPRs). To avoid the loss of transmitted information through distortion during amplification, highly linear transmitters are needed. However, typical linear transmitters are rather power inefficient. Several architectures have been proposed to improve the achievable power efficiency while meeting the communication system standards' linearity requirements. These architectures either consist of using continuously driven PAs, mainly class AB or Doherty, along with linearization techniques, such as e.g. digital predistortion, or using switching mode PAs in an appropriate system level architecture.

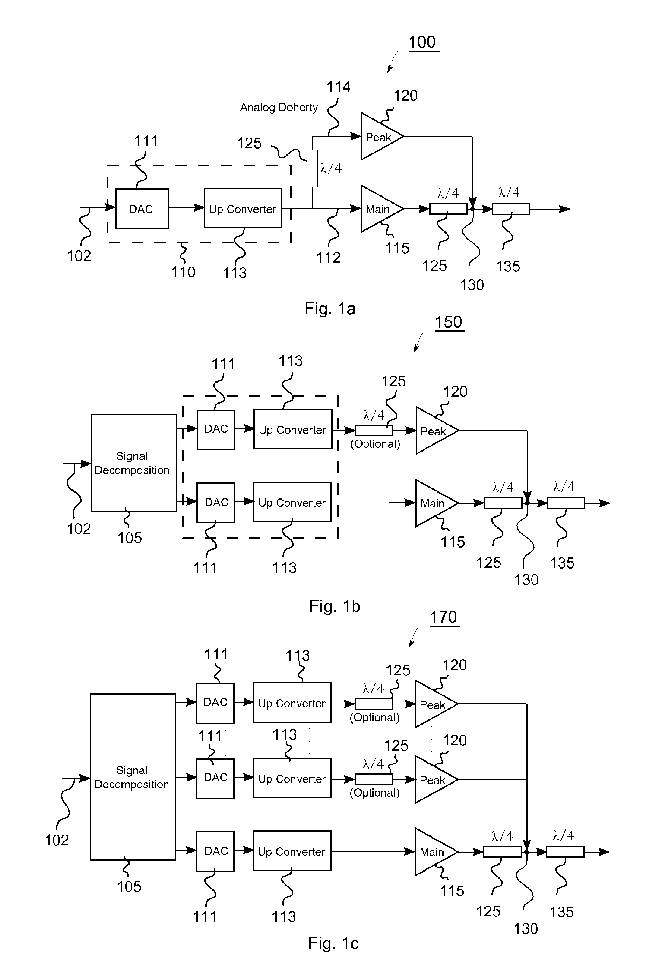

A fully analog single-input Doherty PA architecture 100, which is sketched in Fig. 1a, is widely spread in field-deployed transceivers of wireless communication systems.

A complex- valued digital baseband signal 102, such as a CDMA or OFDMA baseband signal corresponding to one or multiple users, is digital- to- analog converted by at least one (i.e. one or more) Digital- to- Analog Converter (DAC) 111 to obtain an analog baseband signal at the output of the DAC 111. Said analog baseband signal is then up-converted or mixed from the baseband domain to the RF (or an Intermediate Frequency, IF) domain via an up- convertor 113 to obtain an analog RF signal 112 associated to the digital baseband signal 102. Together the at least one DAC 111 and the up- convertor 113 may form a digital- baseband- to- RF circuitry 110. The analog RF signal 112 output from the digital- baseband- to- RF circuitry 110 is then fed to a Doherty PA stage comprising a first PA 115 and a second PA 120. While the input of the first PA 115, also commonly referred to as carrier or main PA, may directly be coupled to the output of the digital- baseband- to- RF circuitry 110, the input of the second PA 120, also commonly referred to as peaking PA, may be coupled to the output of circuit 110 via a quarter- wavelength ($\lambda/4$) transformer circuit 125, which can be a $\lambda/4$- microstrip line, for example. Thereby $\lambda$ typically denotes the wavelength of the wireless system's carrier or some other reference frequency $f_c$. Hence, the analog RF signal 112 may be directly fed to the first PA 115, while a (theoretically) 90°- phase- shifted version thereof may be fed to the second PA 120. A further quarter- wavelength transformer circuit 125 is coupled between the output of the first PA 115 and a connection node 130, while the output of the second PA 120 is directly coupled to said connection node 130, thus achieving a (theoretically) 0°- phase- shift between the signals meeting at node 130.

Hence, the Doherty amplifier 100 comprises a carrier and a peaking amplifier 115, 120 coupled to each other by two quarter- wave transmission lines 125 (one at the input, one at the output) . The carrier PA 115 may typically be biased in the linear class A or class AB mode, while the peaking PA 120 may typically be biased at nonlinear class C mode so that the peaking PA 120 may turn on just before the carrier PA 115 starts to go into compression. The current contribution from the peaking PA is reducing the effective load impedance of the carrier PA 115 and drawing more current from the device 100. Dynamic load adaption is produced by a quarter- wave impedance inverter 125 at the output of the main or carrier PA 115, used in conjunction with a quarter- wave impedance transformer 135. A 50 ohm quarter-wave transmission line impedance inverter 125 is used in classical Doherty designs, accompanied by a 35 Ohm quarter wave transformer 135. The transformer 135 may rotate the 50 Ohm system characteristic impedance down to 25 Ohms at point 130 in Fig. 1. At low power levels, the carrier PA 115 acts as a current source while the class C biased peaking PA is pinched off. Ideally, the peaking amplifier "off- state" output impedance is infinite, effectively appearing as an open circuit to the carrier PA 115. The carrier PA voltage swing looking into a higher transformed load increases, thereby producing higher gain and efficiency. The higher gain compensates somewhat for the gain lost from the as yet non-contributing auxiliary PA 115.

The point at which the peaking PA 120 begins to turn on is the so-called Doherty amplifier transition point. At the transition point the carrier PA 115 is loaded such that it is near saturation. As the amplifier circuit 100 is driven harder the load at point 130 appears larger. The impedance reflected back from point 130 to the carrier PA 115 decreases. The carrier PA 115 remains near saturation while load adapts dynamically, maintaining a high efficiency as power output increases. At rated power both 50 Ohm amplifiers 115, 120 are in parallel, so 25 Ohm net impedance is seen at node 130. The output transformer 135 rotates the 25 Ohm impedance to 50 Ohms, ideally matched to the system characteristic impedance. At maximum power output both amplifiers 115, 120 are operating near saturation and the Doherty PA efficiency reaches a second maximum.

Nonetheless, the analog single- input Doherty PA architecture 100 of Fig. 1 suffers from limitations to its achievable power efficiency. First, the difference in the class of operation of the carrier PA 115 and the peaking PA 120 results in gain imbalance between the two PA branches of Doherty PAs. Uneven power splitting, asymmetrical Doherty PA design, and adaptive gate bias control have previously been proposed to cope with the problem of amplitude imbalance.

At transistor level, replacing Laterally Diffused Metal-Oxide Semiconductor (LDMOS) transistors of the carrier and/or peaking PAs 115, 120 with the increasingly attractive and highly efficient Gallium-Nitride (GaN) devices has given rise to additional challenges for Doherty PA design, especially in terms of phase variation between the carrier and peak PA branches. The difference in bias conditions between the carrier and peak PA results in power-dependent phase variation through the branches of GaN Doherty PAs. For example, the linearizability of Doherty PAs may be achieved in an analog way by using an offset line at the input of the phase lagging path to control the third-order inter-modulation (IM3) distortion cancellation effect at a specific average power level.

Recently, a digital Doherty architecture has been introduced to provide higher performance in terms of power efficiency in comparison to the conventional analog Doherty PA 100. Fig. 1b shows an example of a two- way digital Doherty PA architecture 150, while Fig. 1c shows an example of a general N- way digital Doherty PA architecture 170.

The complex-valued digital baseband signal 102 is fed into a signal decomposition block 105, where the digital baseband signal 102 may be separated into a first (carrier) signal part and at least one second (peaking) signal part. Depending on the art of the Doherty PA and other aspects the signal decomposition may be diverse. Thereby the signal separation or decomposition can take place based on an amplitude or power threshold value. For example, the signal can be equally split into two signal parts for a symmetrical Doherty. Both signal parts may individually be digital-to-analog converted by respective DACs 111 to obtain first and second analog baseband signals, which may then individually be up-converted or mixed from the baseband domain to the RF (or intermediate frequency) domain via respective up-convertors 113 to obtain analog first and second RF signal parts for the carrier and peaking branch, respectively. In the digital Doherty PA architecture 150 the $\lambda/4$-transmission line 125 at the input of the peaking PA 120 is optional, since the 90° phase shift may also be performed upstream by means of digital baseband processing. The rest of the quadrature-like Doherty PA configuration is comparable to Fig. 1a.

Generally, a disadvantage of conventional Doherty PA designs is their comparatively low operation bandwidth. As shown in Figs. 1a, 1b and 1c, the quarter- wavelength transmission lines 125 are used in the analog as well as in the digital Doherty PA design. Both Doherty PAs therefore only work well exactly at the radio frequency defined by the length of the $\lambda/4$- transmission lines, which usually may be the system's operating or carrier frequency $f_c$. In other words, conventional Doherty PA designs are a narrowband PA concept, which exhibits gain and efficiency deterioration at other frequencies than the radio frequency defined by the length of the $\lambda/4$- transmission lines.

Hence, it is desireable to provide a more broadband Doherty power amplifier design.

<u>Summary</u>

As in a digital Doherty PA design the transmit signal is directly decomposed in the digital baseband domain, it is one finding of the present invention to use digital baseband signal processing to compensate for a phase offset mismatch between at least one quarter-wavelength transformer and the frequencies of a useful signal spectrum next to the optimal frequency $f_c$ defined by the length of the quarter-wavelength transformer. That is to say, an exact 90° phase shift by a quarter-wavelength transformer is usually only achieved for signal components of the optimal frequency $f_c$. For neighboring frequencies of the useful signal bandwidth, which may be up to several tens MHz, for example, the resulting phase shift of a quarter-wavelength transformer may be different from the ideal 90°, thus leading to gain and efficiency deterioration. For example, the phase shift may be 85° at the lower end of the useful signal bandwidth, while it may be 95° at the upper end of the useful signal bandwidth. Embodiments of the present invention suggest performing a pre-compensation of the signal phase in the digital baseband domain, such that the RF signals of the main branch (at the main PA's output) and the peaking branch (at peak PA's output) ideally experience the same phase relative shift over the whole useful signal bandwidth, thus leading to a 0°-phase difference over the whole useful signal bandwidth of the main and peaking signals meeting at output node 130.

For that purpose, according to a first aspect, it is provided an amplifier circuit for amplifying a RF signal. The amplifier circuit comprises a digital baseband processor which is operable to decompose a digital baseband signal which has a useful signal bandwidth into a first (carrier) signal part and into a second (peaking) signal part. Further, the amplifier circuit comprises a first (carrier) amplifier operable to amplify a first (carrier) radio frequency signal corresponding or being associated to the first signal part. The amplifier circuit also comprises a second (peaking) amplifier operable to amplify a second (peaking) radio frequency signal corresponding or being associated to the second signal part. The first and the second amplifiers are coupled to each other by means of at least one quarter-wavelength transformer, wherein the at least one quarter-wavelength transformer may be adapted to the wavelength of a predefined reference frequency, which may be a carrier frequency $f_c$ of the first and second radio frequency signal, for example. The at least one quarter-wavelength transformer has a non-constant phase transfer function over the useful signal bandwidth. According to embodiments the digital baseband processor is operable to process the second and/or the first signal part for at least partially pre-compensating the non-constant phase transfer function over the useful signal bandwidth, such that a concatenated or superimposed phase transfer function of the phase pre-compensation and the at least one quarter-wavelength transformer is essentially constant over the useful signal bandwidth. Thereby "essentially" means constant within a small tolerance range around a constant phase value, e.g. 90°. The small tolerance range may, for example, be ±0.2% or ±0.1% of said constant phase value. That is to say, the phase (pre-) compensation is to be understood as a correction of a phase error between the wanted constant phase value and the obtained frequency-dependent phase without said phase (pre-) compensation.

The digital baseband processor may, in some embodiments, be operable to decompose the digital baseband signal equally into the first signal part and into the second signal part. In other embodiments the digital baseband processor may be operable to decompose the digital baseband signal into a first signal part below a predefined threshold and into at least one second signal part above said predefined threshold. In embodiments the first amplifier is adapted for amplifying the first (carrier) signal part of the RF signal, while at least one second amplifier is adapted for amplifying the at least one second (peaking) part of the RF signal. Hence, different parts of the digital baseband signal may be amplified by different amplifiers, possibly depending on the digital baseband signal's level. In other words, according to some embodiments, the second or peaking amplifier branch may be adapted for amplifying the second (peaking) RF signal only if the level of the corresponding digital baseband signal exceeds a certain threshold, and for not amplifying otherwise, e.g. by switching its output to a high impedance otherwise. The level of the digital baseband signal may correspond to its instantaneous amplitude or power. The first and/or the second amplifier may comprise transistors for amplifying, respectively. Such transistors may be from the group of GaN, GaAs, $GaC_2$, Ge, Si, SiGe, LDMOS, MOSFET (Metal Oxide Semiconductor Field Effect Transistor), IGBT (Insulated Gate Bipolar Transistor), BJT (Bipolar Junction Transistor), JFET (Junction Gate Field-Effect Transistor), IGFET (Insulated Gate FET). For example, the first (main or carrier) transistor may correspond to a GaN-transistor. The second (peaking) transistor may also correspond to a GaN- or to a LDMOS-transistor.

The first and second amplifier may be coupled to form a Doherty amplifier circuit. Thereby, the first and the second amplifier branch may form a symmetric or an asymmetric Doherty amplifier circuit. In some embodiments the amplifier circuit may further comprise a (digital) power distribution block for distributing the power of the signals between the first and the second amplifier branches according to a predefined ratio. For example, the power distribution block may be comprised by the digital baseband processor. The predefined ratio can, for example, be such that the second amplifier provides at least 2/3 of a total output power of both amplifiers when both amplifiers provide their maximum output power.

According to various embodiments a quarter-wavelength transformer may be understood as a transmission line impedance transformer, wherein the transmission line has a length corresponding to a quarter wavelength or odd multiples thereof of a given reference frequency. This reference frequency may, for example, be the carrier or center frequency $f_c$ of the RF signal(s). However, other reference frequencies for the quarter-wavelength transformer are also conceivable.

The amplifier circuit may be deployed in an entity of a wireless communication system, such as, for example, a wireless communication systems standardized by the 3rd Generation Partnership Project (3GPP), as the Global System for Mobile Communications (GSM), Enhanced Data rates for GSM Evolution (EDGE), GSM/EDGE Radio Access Network (GERAN), Universal Terrestrial Radio Access Network (UTRAN) or Evolved UTRAN (E-UTRAN), Long Term Evolution (LTE) or LTE-Advanced (LTE-A), or wireless communication systems with different standards, e.g. Worldwide Interoperability for Microwave Access (WIMAX) IEEE 802.16 or Wireless Local Area Network (WLAN) IEEE 802.11, generally any system based on Time Division Multiple Access (TDMA), Frequency Division Multiple Access (FDMA), Orthogonal Frequency Division Multiple Access (OFDMA), Code Division Multiple Access (CDMA), etc. In the following the terms wireless communication system and mobile communication network may be used synonymously. Note that the concept of the present invention is not limited to the aforementioned wireless communication systems but is also applicable to other as well as future wireless communication system standards.

For example, the amplifier circuit may be deployed in a base station transceiver. A base station transceiver may correspond to a remote radio head, a transmission point, an access point, a macro cell, a small cell, a micro cell, a femto cell, a metro cell etc. A base station can be a wireless interface of a wired network, which enables transmission of radio signals in different RF bands to an associated UE or mobile terminal. Such a radio signal may comply with radio signals as, for example, standardized by 3GPP or, generally, in line with one or more of the above listed systems. Thus, a base station may correspond to a NodeB, an eNodeB, a BTS, an access point, etc.

According to other embodiments, the amplifier circuit may also be deployed in a mobile terminal transceiver, wherein a mobile terminal may correspond to a smartphone, a cell phone, user equipment, a laptop, a notebook, a personal computer, a Personal Digital Assistant (PDA), a Universal Serial Bus (USB) -stick, a car, etc. As mentioned before, a mobile terminal may also be referred to as User Equipment (UE) in line with the 3GPP terminology. Further, the multiband transceiver apparatus may also be coupled to a relay station for relaying wireless signals from a base station to a mobile terminal, and vice versa.

According to a further aspect it is also provided a radio transceiver or transmitter comprising an amplifier circuit according to embodiments.

According to yet a further aspect it is provided a method for amplifying a (RF) signal. The method comprises a step of decomposing a digital baseband signal having a useful signal bandwidth into a first digital baseband signal part and into a second digital baseband signal part. In a second step, a first amplifier is used for amplifying a first radio frequency signal corresponding or being associated to the first digital baseband signal part. Typically, the first radio frequency signal will have a certain carrier frequency. In a further step, a second amplifier is used for amplifying a second radio frequency signal corresponding or being associated to the second digital baseband signal part, wherein the second radio frequency signal may also have said carrier frequency. For the method the first and the second amplifiers are coupled to each other by means of at least one quarter-wavelength transformer matched to a predefined reference frequency, thus the quarter-wavelength transformer having a non-constant phase transfer function over the useful signal bandwidth. Before amplifying the first and the second radio frequency signals, the method comprises a step of processing the second and/or the first digital baseband signal part for at least partially pre-compensating the non-constant phase transfer function of the at least one quarter-wavelength transformer, such that a concatenated phase transfer function resulting from the phase pre-compensation and the at least one quarter-wavelength transformer is essentially constant over the useful signal bandwidth.

Some embodiments comprise a digital control circuit installed within the amplifier circuit. Such a digital control circuit, e.g. a digital signal processor (DSP) or an Application Specific Integrated Circuit (ASIC), needs to be programmed accordingly. Hence, yet further embodiments also provide a computer program having a program code for performing embodiments of the method or at least individual steps thereof, when the computer program is executed on a computer or a digital processor.

Embodiments of the present invention allow for compensating a phase mismatch caused by the quarter-wavelength transformer(s) designed for a certain reference wavelength or frequency. In this way, a digital Doherty PA can be used as a broadband PA. By means of the phase (pre-) compensation the bandwidth of a digital Doherty PA can be extended from several MHz to theoretically infinite, if other bandwidth limiting factors are not concerned. Furthermore, since the phase mismatch of the Doherty PA may be fixed during its operation, no adaptation of the phase pre-compensation may even be required.

Brief description of the Figures

Some embodiments of apparatuses and/or methods will be described in the following by way of example only, and with reference to the accompanying figures, in which

Fig. 1a    shows a block diagram of a conventional analog Doherty power amplifier;

Fig. 1b    shows a block diagram of a conventional (partly) digital Doherty power amplifier;

Fig. 1c    shows a block diagram of a digital N-way digital Doherty power amplifier;

Fig. 2a    shows a block diagram of a power amplifier circuit according to a first embodiment of the present invention;

Fig. 2b    shows a block diagram of a power amplifier circuit according to a second embodiment of the present invention;

Fig. 3a illustrates a phase mismatch/deviation for frequencies different from a reference frequency of a quarter-wavelength transformer;

Fig. 3b illustrates a phase and gain transfer function of a phase pre-compensation filter according to an embodiment;

Fig. 4a illustrates efficiencies for a conventional (partly) digital Doherty power amplifier; and

Fig. 4b illustrates efficiencies for a (partly) digital Doherty power amplifier according to an embodiment.

Description of Embodiments

Various example embodiments will now be described more fully with reference to the accompanying drawings in which some example embodiments are illustrated. In the figures, the thicknesses of lines, layers and/or regions may be exaggerated for clarity.

Accordingly, while example embodiments are capable of various modifications and alternative forms, embodiments thereof are shown by way of example in the figures and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

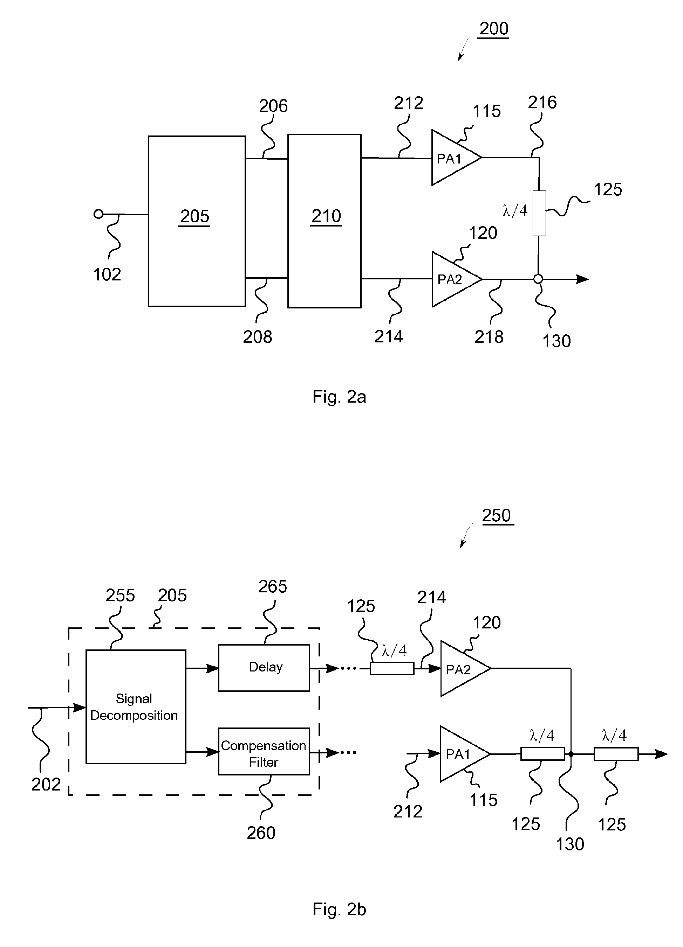

Fig. 2a illustrates an amplifier circuit 200 in a digital Doherty PA setup, according to an embodiment of the present invention.

The amplifier circuit 200 comprises a digital baseband processor 205 operable to decompose or split a digital baseband signal 102 having a useful signal bandwidth into a first (carrier) signal part and into a second (peaking) signal part. For example, the digital baseband signal 102 may be an OFDM signal or a CDMA signal of one or multiple users. Thereby the first signal part of the digital baseband signal 102 can be formed by one half of the digital baseband signal, whereas the second signal part can be formed by the other half of the digital baseband signal, for the case of a symmetric Doherty. For an asymmetric Doherty or other reasons the baseband signal can be decomposed by other principles as well. For example, the first signal part of the digital baseband signal 102 can be formed by digital baseband signal parts below a predefined signal threshold, whereas the second part may be formed by signal parts above said signal threshold.

A first (carrier) amplifier 115 of the amplifier circuit 200 is operable to amplify a first RF signal 212 corresponding to the first (digital baseband) signal part. A second (peaking) amplifier 115 is operable to amplify a second RF signal 214 corresponding to the second (digital baseband) signal part. The first and the second RF signals may be obtained from the first and second digital baseband signal parts by digital- to- analog conversion and frequency up- conversion in an intermediate or transmission band, respectively, which may take place in a digital- baseband- to- RF circuitry 210. Both RF signals 212, 214 may have the same useful signal or transmission bandwidth around a common carrier or center frequency $f_c$. The first and the second amplifier's 115, 120 outputs are coupled to each other by means of at least one quarter- wavelength transformer which is adapted to predefined reference wavelength or frequency. Thus the at least one quarter- wavelength transformer 125 has a non- constant phase transfer function over the useful signal bandwidth. That is to say, the phase transfer function of the at least one quarter- wavelength transformer 125 may vary versus the frequencies within the useful signal bandwidth. A typical implementation for the at least one quarter- wavelength transformer 125 may be a $\lambda/4$- microstrip line, connecting the output of the first PA 115 to the output of the second PA 120 in node 130 ($\lambda$ denoting the reference wavelength).

According to embodiments, the digital baseband processor 205 may be operable or adapted to (pre-) process the second and/or the first digital baseband signal part in order to at least partially pre-compensate the non-constant phase transfer function of the at least one quarter-wavelength transformer 125 in the useful signal bandwidth, such that a phase difference between the first and the second RF signals meeting at node 130 is essentially a constant phase value, e.g. 0°, over the whole useful signal bandwidth. That is to say, a concatenated or superimposed phase transfer function of a phase pre-compensation entity  and the at least one quarter-wavelength transformer yields an essentially constant/frequency-independent phase value over the useful signal bandwidth, whereby "essentially" means constant within a predefined tolerance range around said constant phase value, e.g. 90° (or odd multiples thereof). The small tolerance range may, for example, be $\pm 0.2\%$ or $\pm 0.1\%$ of said constant phase value.

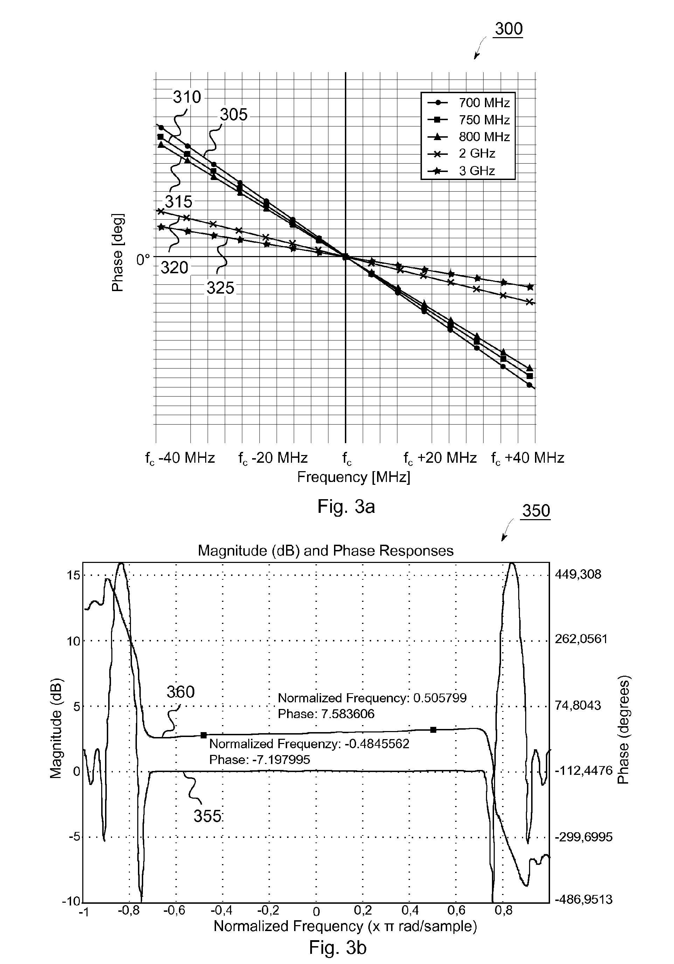

According to embodiments the first amplifier 115 may comprise at least one first (power) transistor and the second amplifier 120 may comprise at least one second (power) transistor. As can be seen from Fig. 2a, the first amplifier 115 and the second amplifier 120 may be arranged in a Doherty amplifier configuration, i.e., the two amplifiers 115, 120 may be arranged in parallel with the characteristic $\lambda/4$-microstrip line 125 coupling the outputs of the first and second PAs 115, 120 to obtain a combined radio frequency signal at the common output node 130 of the amplifier circuit 200. Thereby, the $\lambda/4$-microstrip line 125 may, for example, be fitted or matched to the carrier or center frequency $f_c$ of the RF signals 112, 114 as the reference frequency. Without any phase compensation the amplified RF signals meeting at node 130 would only be phase shifted to each other by exactly 0° at the reference frequency for which the $\lambda/4$-microstrip line 125 has been designed, i.e. the carrier frequency $f_c$, for example. For the remaining frequencies within the transmission bandwidth, however, there would be a phase-offset mismatch, i.e. phase-offsets different from 0°. In other words, the phase shift between the two amplified RF signal parts is frequency dependent and deviates the stronger from the ideal 0° phase offset the more the frequency deviates from the reference frequency (or the respective wavelength) for which the $\lambda/4$-microstrip line 125 has been designed. This is shown in Fig. 3a for different exemplary carrier frequencies and a signal bandwidth of exemplary 88 MHz.

As becomes apparent from curves 305 to 325 of Fig. 3a, the phase offset of a $\lambda/4$-microstrip line 125 is a function of frequency. While for all considered reference frequencies (700 MHz, 750 MHz, 800 MHz, 2 GHz, and 3 GHz) and the respectively adapted $\lambda/4$-microstrip lines 125 there is an ideal 90° phase offset of a $\lambda/4$-microstrip line 125 at the respective reference frequency $f_c$, leading to an ideal phase offset of 0° between the amplified first (carrier) and second (peaking) RF signals meeting at node 130, the phase offset between the amplified first (carrier) and second (peaking) RF signals  meeting at node 130 becomes larger than 0° for frequencies smaller than $f_c$, and smaller than 0° for frequencies larger than $f_c$. As may be seen from Fig. 3a there is a linear dependency between frequency and phase offset deviation $ph(f)$ due to the frequency dependent behavior of the $\lambda/4$-microstrip line 125, which may be expressed by

$$ph(f) = \left( \frac{f_c}{f} - 1 \right) \cdot \frac{\pi}{2} \ , \qquad\qquad (1)$$

wherein $f_c$ denotes the (optimal) frequency for which the $\lambda/4$-microstrip line 125 has been designed.

Therefore the digital baseband processor 205 may be operable to pre-process the second and/or the first (digital baseband) signal part such that a phase difference is between the first and the second amplified RF signal at node 130 is essentially 0° and frequency-independent over the whole useful signal bandwidth. Here, the term "essentially" is to be understood such that the phase difference is between the first and the second amplified RF signal at node 130 preferably lies within a phase interval of 0°$\pm 0.1°$ over the whole useful signal bandwidth. Since in a digital Doherty PA, according to embodiments of the present invention, the transmit signal is directly decomposed in carrier and peaking part in the digital baseband domain, some embodiments propose to deploy a special digital phase pre-compensation filter to compensate for the phase mismatch between the at least one quarter-wavelength microstrip 125 and the frequencies next to the optimal frequency $f_c$. As one can determine the phase mismatch between the at least one quarter-wavelength microstrip 125 and the frequencies within the useful signal bandwidth, one can apply a digital filter with a flat gain response within the desired signal bandwidth but with a phase transfer function which is complementary to the above phase offset deviation $ph(f)$ in order to compensate the mismatch. That is to say, the digital phase pre-compensation filter may have an all-pass filter characteristic over the useful signal bandwidth of the digital baseband signal 102.

Such a digital phase pre- compensation filter 260 is sketched in the exemplary embodiment illustrated in Fig. 2b. As the digital- baseband- to- RF circuitry 210 has already been  explained with reference to Fig. 2a, its depiction and explanation is omitted here for the sake of clarity. According to the exemplary embodiment illustrated of Fig. 2b, the digital baseband processor 205 of the amplifier circuit 250 comprises a signal decomposition block 255 for decomposing or separating the digital baseband signal 102 into the carrier signal part and into the peaking signal part, as has been described before. The digital baseband signal branch related to the carrier signal part may comprise a digital phase pre-compensation all- pass filter 260, which may be realized as a Finite Impulse Response (FIR) filter, for example. Of course, other filter techniques known in the art for realizing all- pass filter characteristics are also conceivable. Due to the all- pass FIR filter 260 the carrier digital baseband signal part may experience a filter delay when travelling through the filter 260. Therefore, in some embodiments, the peaking digital baseband signal part may by delayed by said filter delay on its way to the carrier amplifier 115 by a corresponding delay element 265 for achieving time alignment of the peaking and carrier signal parts.

It will be apparent to the skilled person that the digital phase pre-compensation filter 260, which may be located in the carrier digital baseband signal branch according to the sketched exemplary embodiment, may also be located in the peaking digital baseband signal branch, or may be distributed among both branches in other embodiments. In the end a defined phase offset of 0° over the whole useful signal bandwidth should be achieved between the amplified RF signals coming from the PAs 115 and 120, meeting each other at network node 130. For this purpose the phase pre-compensation filter 260 may realize a complementary or inverse phase transfer function compared to the non-ideal phase transfer function of the at least one the $\lambda/4$-microstrip line 125. In other words, the phase transfer function of the phase pre-compensation filter 260 in the useful signal bandwidth may be $-ph(f)$, i.e.

$$- ph(f) = \left(1 - \frac{f_c}{f}\right) \cdot \frac{\pi}{2}. \qquad\qquad (2)$$

For example, optimized complex compensation filter coefficients for an optimal reference frequency of $f_c = 738$ MHz may be given by:

fil_738=[ 1.125190363745646 + 0.000005696707678i -0.254486135154178 - 0.000080438879771i 0.214850358722357 + 0.000235293757826i -0.136203103476044 - 0.000517625704022i -0.004871271738876 + 0.000786399616313i 0.187743323013520 - 0.000941094936352i - 0.360709129464502 + 0.000835854196888i 0.458940085926230 - 0.000464044157208i -0.431185686843956 - 0.000099695810244i 0.265112073215535 + 0.000667482752821i 0.000842292757833 - 0.001028201239159i -0.286529748125161 + 0.001016595501670i 0.498150492069558 - 0.000598349324398i -0.564246221164454 - 0.000096263296677i 0.463875505062268 + 0.000827153228559i -0.234472306686185 - 0.001288519887850i -0.043945536863033 + 0.001269917622170i 0.280805659232676 - 0.000786059213787i - 0.408820020257363 + 0.000052033304769i 0.405632493417597 + 0.000623755782414i -0.295507073154430 - 0.001014793850431i 0.132859102347147 + 0.000999180413220i 0.022853117185038 - 0.000621964948736i -0.129252831323147 + 0.000052072074413i 0.171547025333462 + 0.000499809464292i -0.159955108331445 - 0.000848165673494i 0.118288027746541 + 0.000929164480912i -0.070884406106483 - 0.000756541513370i 0.033655433867231 + 0.000485181771166i -0.011723075174355 - 0.000209774824852i 0.002340222219364 + 0.000069552617367i].

The filter's magnitude and phase responses versus frequency are presented in Fig. 3b. The curves 355 and 360 indicate the filter's amplitude/gain and phase response, respectively. The gain and phase transfer functions 355 and 360 each have two ripples at the edge of the pass band, which are however not located within the useful signal bandwidth, i.e. the passband. One can therefore neglect these ripples. In the useful signal bandwidth the filter's phase transfer function corresponds to Eq. (2) and is, hence, complementary to the phase offset mismatch due to the at least one $\lambda/4$-microstrip line 125 described by Eq. (1). The gain transfer function 355 is essentially constant at 0 dB within the useful signal bandwidth. Furthermore, the ripples in the filter's gain and phase transfer functions 355 and 360 can be reduced by further optimization processes.

Hence, as has been explained above, the digital baseband processor 205 may comprise a digital phase pre-compensation filter 260 for digitally filtering the first and/or the second signal part, wherein the digital phase pre- compensation filter 260 essentially has a constant  gain over the useful signal bandwidth and a filter phase transfer function over the useful signal bandwidth, which essentially compensates the non- constant phase transfer function of the at least one $\lambda/4$- transformer 125, such that a concatenation of the digital phase pre- compensation filter 260 and the at least one $\lambda/4$- transformer 125 yields an essentially constant phase transfer function over the useful signal bandwidth. Thereby the digital phase pre- compensation filter 260 may not only compensate the $\lambda/4$- transformer 125 coupled to the output of the carrier amplifier 115, but it may also compensate non- ideal phase effects of a further optional $\lambda/4$- transformer 125 coupled to the input of the peaking amplifier 120.

As can be seen from Fig. 2b, the input of the peaking amplifier 120 may be, compared to the carrier signal part, a phase- shifted version of the peaking signal part. The phase- shifted version of the peaking signal part may have a peaking signal phase shifted relative to a signal phase of the carrier signal part by essentially 90°, as known from Doherty PA concepts. The 90°- phase- shift may either be performed by a $\lambda/4$- transformer 125 in the RF domain (as indicated by Fig. 2b), wherein the $\lambda/4$- transformer 125 couples the up- converted peaking RF signal part to the input of the peaking amplifier 120, thereby introducing a (non- ideal) 90° phase shift relative to the carrier signal branch. According to some embodiments, the 90° phase shift may be as well performed in the digital baseband domain by the digital baseband processor 205, e.g. by multiplying samples of the digital baseband peaking signal by a factor $e^{j\pi/2}$. This factor may be accounted for in the filter coefficients of the filter 260, for example.

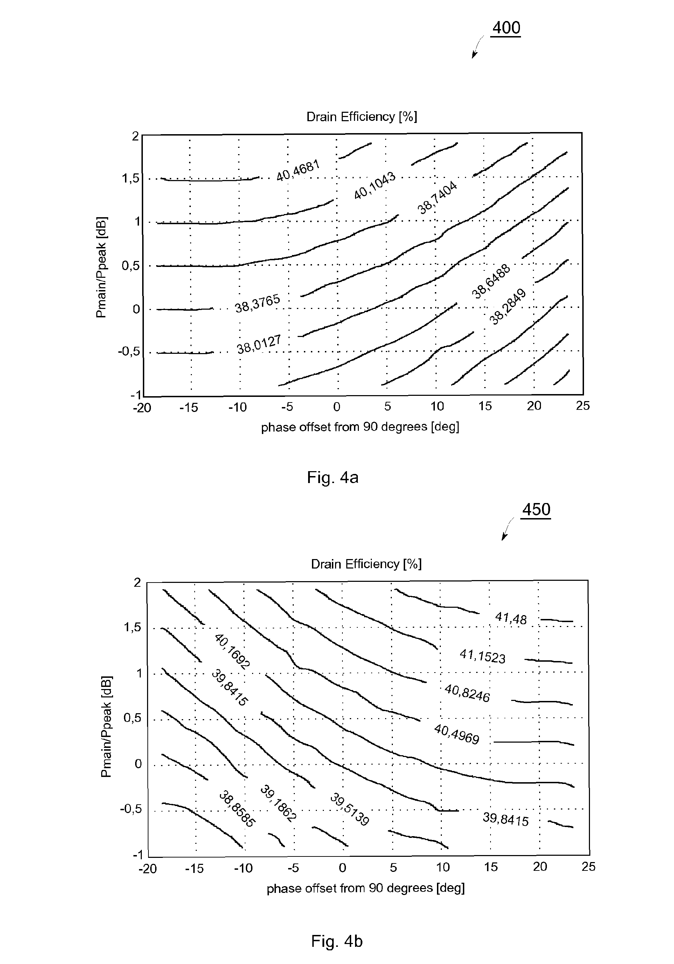

In order to compare embodiments of the present invention with conventional digital Doherty PAs, like the one presented in Fig. 1b, a 3 x 5MHz LTE carrier signal with 12.5 MHz frequency spacing between each LTE signal and hence 40 MHz of useful signal bandwidth has been applied to a conventional Doherty amplifier and a Doherty amplifier according to an embodiment. Fig. 4a shows the efficiency performance 400 of a conventional Doherty amplifier without broadband compensation, while Fig. 4b shows an improvement in efficiency performance 450 of a Doherty amplifier with the broadband compensation technique, according to an embodiment. For example, for a symmetric Doherty setup, i.e. $P_{main}/P_{peak} = 0$ dB, Fig. 4a indicates an efficiency of the conventional Doherty amplifier of 38.3765%. With broadband compensation the same symmetric Doherty setup ($P_{main}/P_{peak} = 0$ dB) yields an improved efficiency of 40.4969 % according to Fig. 4b. Similarly, for an asymmetric Doherty setup of $P_{main}/P_{peak} = 1.5$ dB, Fig. 4a indicates an efficiency of the conventional Doherty amplifier of 40.4681%, while the same asymmetric Doherty setup ($P_{main}/P_{peak} = 1.5$ dB) yields an improved efficiency of 41.48 % according to Fig. 4b.

To summarize, embodiments of the present invention allow for compensating a quarter-wavelength transformer's phase mismatch relative to 90° (or multiples thereof) caused by the quarter-wavelength transformer(s) in the presence of a broadband input signal. In this way, a digital Doherty PA can advantageously be used as a broadband PA. By means of the proposed phase compensation the signal bandwidth of a digital Doherty PA can be extended from several MHz to theoretically infinite. Furthermore, since the phase mismatch of the Doherty PA may be fixed during its operation, no adaptation of the phase pre-compensation may even be required. However, in embodiments the digital baseband processor may also be operable to adaptively process the second and/or the first signal part for at least partially pre-compensating an adaptively varying phase transfer function of the at least one least one quarter-wavelength transformer in the useful signal band.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks denoted as "means for ..." (performing a certain function) shall be understood as functional blocks comprising circuitry that is adapted for performing a certain function, respectively. Hence, a "means for s.th." may as well be understood as a "means being adapted or suited for s.th.". A means being adapted for performing a certain function does, hence, not imply that such means necessarily is performing said function (at a given time instant).

Functions of various elements shown in the figures, including any functional blocks may be provided through the use of dedicated hardware, as e.g. a processor, as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and nonvolatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that- although a dependent claim may refer in the claims to a specific combination with one or more other claims- other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

**Claims**

1.  An amplifier circuit (200; 250), comprising:

    a digital baseband processor (205) operable to decompose a digital baseband signal (102) having a useful signal bandwidth into a first signal part and into a second signal part;
    a first amplifier (115) operable to amplify a first radio frequency signal (212) corresponding to the first signal part;
    a second amplifier (120) operable to amplify a second radio frequency signal (214) corresponding to the second signal part;

    wherein the first and the second amplifiers (115; 120) are coupled to each other by means of at least one quarter-wavelength transformer (125) having a non-constant phase transfer function over the useful signal bandwidth; and
    wherein the digital baseband processor (205) is operable to process the second and/or the first signal part for at least partially pre-compensating the non-constant phase transfer function.

2.  The amplifier circuit (200; 250) according to claim 1, wherein the at least one quarter-wavelength transformer (125) comprises at least one quarter-wavelength transmission line matched to a reference wavelength.

3.  The amplifier circuit (200; 250) according to claim 1, wherein the first and the second amplifiers (115; 120) are coupled in parallel.

4.  The amplifier circuit (200; 250) according to claim 1, wherein the first amplifier (115) comprises at least one first transistor, wherein the second amplifier (120) comprises at least one second transistor, and wherein the at least one first and at least one second transistors are arranged in a Doherty amplifier configuration.

5.  The amplifier circuit (200; 250) according to claim 1, wherein an output of the first amplifier (115) is coupled to an output of the second amplifier (120) by means of a quarter-wavelength transmission line (125) to obtain a combined radio frequency signal at a common output node (130) of the amplifier circuit (200; 250), wherein the digital baseband processor (205) is operable to process the second and/or the first signal part such that a phase difference is between the first and the second radio frequency signal at the common output node (130) is essentially frequency independent over the useful signal bandwidth.

6.  The amplifier circuit (200; 250) according to claim 1, wherein an input of the second amplifier (120) is coupled to a phase-shifted version of the second signal part, wherein the phase-shifted version of the second signal part has a signal phase shifted to a signal phase of the first signal part by essentially 90° relative to the first signal part.

7.  The amplifier circuit (200; 250) according to claim 6, wherein the 90° phase shift is performed by a quarter-wavelength transmission line (125) in the radio frequency domain, the quarter-wavelength transmission line (125) coupling the second signal part to the input of the second amplifier (120).

8.  The amplifier circuit (200; 250) according to claim 6, wherein the 90° phase shift is performed by the digital baseband processor (205) in the digital baseband domain.

9.  The amplifier circuit (200; 250) according to claim 1, wherein the digital baseband processor (205) comprises a digital phase pre-compensation filter (260) for digitally filtering the first and/or the second signal part, wherein the digital phase pre-compensation filter (260) has an essentially constant gain over the useful signal bandwidth and a filter phase transfer function over the useful signal bandwidth, which is essentially complementary to the non-constant phase transfer function of the at least one quarter-wavelength transformer (125), such that a concatenation of the digital phase pre-compensation filter (250) and the at least one quarter-wavelength transformer (125) yields an essentially constant phase transfer function over the useful signal bandwidth.

10. The amplifier circuit (200; 250) according to claim 9, wherein the digital phase pre-compensation filter (260) has an all-pass filter characteristic over the useful signal bandwidth of the digital baseband signal (102).

11. The amplifier circuit (200; 250) according to claim 9, wherein the digital phase pre-compensation filter (260) has a filter delay, and wherein the second and/or the first signal part is delayed by said filter delay on its way to the first amplifier (115).

12. The amplifier circuit (200; 250) according to claim 1, wherein digital baseband signal (102) is an Orthogonal Frequency Division Multiplex (OFDM) signal or a Code Division Multiple Access (CDMA) signal.

13. A radio transceiver comprising the amplifier circuit (200; 250) according to claim 1.

14. A method for amplifying a signal, the method comprising:

decomposing a digital baseband signal (102) having a useful signal bandwidth into a first digital baseband signal and into a second digital baseband signal part;
using a first amplifier (115) for amplifying a first radio frequency signal (212) corresponding to the first digital baseband signal part;
using a second amplifier (120) for amplifying a second radio frequency signal (214) corresponding to the second digital baseband signal part;

wherein the first and the second amplifiers (115; 120) are coupled to each other by means of at least one quarter-wavelength transformer (125) having a non-constant phase transfer function over the useful signal bandwidth; and before amplifying the first and/or the second radio frequency signal (212; 214):

processing the second and/or the first digital baseband signal part for at least partially pre-compensating the non-constant phase transfer function.

15. A computer program having a program code for performing the at least one step of the method of claim 14, when the computer program is executed on a computer or processor.


**Amended claims in accordance with Rule 137(2) EPC.**

1. An amplifier circuit (200; 250), comprising:

a digital baseband processor (205) operable to decompose a digital baseband signal (102) having a useful signal bandwidth into a first signal part and into a second signal part;
a first amplifier (115) operable to amplify a first radio frequency signal (212) corresponding to the first signal part;
a second amplifier (120) operable to amplify a second radio frequency signal (214) corresponding to the second signal part;
wherein the first and the second amplifiers (115; 120) are coupled to each other by means of at least one quarter-wavelength transformer (125) having a non-constant phase transfer function over the useful signal bandwidth; and
wherein the digital baseband processor (205) is operable to process the second and/or the first signal part for at least partially pre-compensating the non-constant phase transfer function, such that a concatenated phase transfer function of the phase pre-compensation and the at least one quarter-wavelength transformer is essentially constant over the useful signal bandwidth.

2. The amplifier circuit (200; 250) according to claim 1, wherein the at least one quarter-wavelength transformer (125) comprises at least one quarter-wavelength transmission line matched to a reference wavelength.

3. The amplifier circuit (200; 250) according to claim 1, wherein the first and the second amplifiers (115; 120) are coupled in parallel.

**4.** The amplifier circuit (200; 250) according to claim 1, wherein the first amplifier (115) comprises at least one first transistor, wherein the second amplifier (120) comprises at least one second transistor, and wherein the at least one first and at least one second transistors are arranged in a Doherty amplifier configuration.

**5.** The amplifier circuit (200; 250) according to claim 1, wherein an output of the first amplifier (115) is coupled to an output of the second amplifier (120) by means of a quarter-wavelength transmission line (125) to obtain a combined radio frequency signal at a common output node (130) of the amplifier circuit (200; 250), wherein the digital baseband processor (205) is operable to process the second and/or the first signal part such that a phase difference is between the first and the second radio frequency signal at the common output node (130) is essentially frequency independent over the useful signal bandwidth.

**6.** The amplifier circuit (200; 250) according to claim 1, wherein an input of the second amplifier (120) is coupled to a phase-shifted version of the second signal part, wherein the phase-shifted version of the second signal part has a signal phase shifted to a signal phase of the first signal part by essentially 90° relative to the first signal part.

**7.** The amplifier circuit (200; 250) according to claim 6, wherein the 90° phase shift is performed by a quarter-wavelength transmission line (125) in the radio frequency domain, the quarter-wavelength transmission line (125) coupling the second signal part to the input of the second amplifier (120).

**8.** The amplifier circuit (200; 250) according to claim 6, wherein the 90° phase shift is performed by the digital baseband processor (205) in the digital baseband domain.

**9.** The amplifier circuit (200; 250) according to claim 1, wherein the digital baseband processor (205) comprises a digital phase pre-compensation filter (260) for digitally filtering the first and/or the second signal part, wherein the digital phase pre-compensation filter (260) has an essentially constant gain over the useful signal bandwidth and a filter phase transfer function over the useful signal bandwidth, which is essentially complementary to the non-constant phase transfer function of the at least one quarter-wavelength transformer (125), such that a concatenation of the digital phase pre-compensation filter (250) and the at least one quarter-wavelength transformer (125) yields an essentially constant phase transfer function over the useful signal bandwidth.

**10.** The amplifier circuit (200; 250) according to claim 9, wherein the digital phase pre-compensation filter (260) has an all-pass filter characteristic over the useful signal bandwidth of the digital baseband signal (102).

**11.** The amplifier circuit (200; 250) according to claim 9, wherein the digital phase pre-compensation filter (260) has a filter delay, and wherein the second and/or the first signal part is delayed by said filter delay on its way to the first amplifier (115).

**12.** The amplifier circuit (200; 250) according to claim 1, wherein digital baseband signal (102) is an Orthogonal Frequency Division Multiplex (OFDM) signal or a Code Division Multiple Access (CDMA) signal.

**13.** A radio transceiver comprising the amplifier circuit (200; 250) according to claim 1.

**14.** A method for amplifying a signal, the method comprising:

a) decomposing a digital baseband signal (102) having a useful signal bandwidth into a first digital baseband signal and into a second digital baseband signal part;
b) using a first amplifier (115) for amplifying a first radio frequency signal (212) corresponding to the first digital baseband signal part;
c) using a second amplifier (120) for amplifying a second radio frequency signal (214) corresponding to the second digital baseband signal part;
wherein the first and the second amplifiers (115; 120) are coupled to each other by means of at least one quarter-wavelength transformer (125) having a non-constant phase transfer function over the useful signal bandwidth; and
before amplifying the first and/or the second radio frequency signal (212; 214):
d) processing the second and/or the first digital baseband signal part for at least partially pre-compensating the non-constant phase transfer function, such that a concatenated phase transfer function of the phase pre-compensation and the at least one quarter-wavelength transformer is essentially constant over the useful signal bandwidth.

**15.** A computer program having a program code for performing the steps a) and d) of the method of claim 14, when the computer program is executed on a computer or processor.

<u>100</u>

Analog Doherty

Fig. 1a

<u>150</u>

Fig. 1b

<u>170</u>

Fig. 1c

Fig. 2a

Fig. 2b

300

310
305
315
320
325

Phase [deg]

0°

700 MHz
750 MHz
800 MHz
2 GHz
3 GHz

f$_c$ -40 MHz    f$_c$ -20 MHz    f$_c$    f$_c$ +20 MHz    f$_c$ +40 MHz

Frequency [MHz]

Fig. 3a

350

Magnitude (dB) and Phase Responses

360

Normalized Frequency: 0.505799
Phase: 7.583606

Normalized Frequenzy: -0.4845562
Phase: -7.197995

355

15
10
5
0
-5
-10

Magnitude (dB)

449,308
262,0561
74,8043
-112,4476
-299,6995
-486,9513

Phase (degrees)

-1    -0,8    -0,6    -0,4    -0,2    0    0,2    0,4    0,6    0,8

Normalized Frequency (x π rad/sample)

Fig. 3b

400

Drain Efficiency [%]

Fig. 4a

450

Drain Efficiency [%]

Fig. 4b

Europäisches
Patentamt

European
Patent Office

Office européen
des brevets

**EUROPEAN SEARCH REPORT**

Application Number

EP 12 30 5465

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2007/117189 A1 (ERICSSON TELEFON AB L M [SE]; FONDEN TONY [SE]; HELLBERG RICHARD [SE];) 18 October 2007 (2007-10-18) * page 1, lines 7-12 * * page 13, line 9 - page 20, line 11; figures 3,4,5 * | 1-8, 12-15 | INV. H03F1/02 H03F3/24 H03F1/32 H03F1/42 |
| X | US 7 619 468 B1 (BOWLES GREGORY J [CA] ET AL) 17 November 2009 (2009-11-17) * column 3, line 26 - column 9, line 4; figures 1,2,3,4,5 * | 1-8, 12-15 | |
| X | RAMZI DARRAJI ET AL: "Digital Doherty amplifier with complex gain compensation apparatus", MICROWAVE CONFERENCE PROCEEDINGS (APMC), 2011 ASIA-PACIFIC, IEEE, 5 December 2011 (2011-12-05), pages 122-126, XP032152586, ISBN: 978-1-4577-2034-5 * page 122, right-hand column, line 34 - page 125, right-hand column, line 40; figures 1,2,3,4,5,6,7 * | 1-8, 12-15 | TECHNICAL FIELDS SEARCHED (IPC) H03F H04B H04L |

The present search report has been drawn up for all claims

| Place of search | Date of completion of the search | Examiner |
|---|---|---|
| The Hague | 13 September 2012 | Fedi, Giulio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**ANNEX TO THE EUROPEAN SEARCH REPORT
ON EUROPEAN PATENT APPLICATION NO.**

EP 12 30 5465

This annex lists the patent family members relating to the patent documents cited in the above-mentioned European search report.
The members are as contained in the European Patent Office EDP file on
The European Patent Office is in no way liable for these particulars which are merely given for the purpose of information.

13-09-2012

| Patent document cited in search report | | Publication date | Patent family member(s) | | Publication date |
|---|---|---|---|---|---|
| WO 2007117189 | A1 | 18-10-2007 | AT | 473549 T | 15-07-2010 |
| | | | CN | 101416383 A | 22-04-2009 |
| | | | EP | 2005580 A1 | 24-12-2008 |
| | | | JP | 2009533947 A | 17-09-2009 |
| | | | US | 2009163154 A1 | 25-06-2009 |
| | | | WO | 2007117189 A1 | 18-10-2007 |
| US 7619468 | B1 | 17-11-2009 | CN | 102165686 A | 24-08-2011 |
| | | | EP | 2342817 A1 | 13-07-2011 |
| | | | JP | 2012504355 A | 16-02-2012 |
| | | | KR | 20110066209 A | 16-06-2011 |
| | | | US | 7619468 B1 | 17-11-2009 |
| | | | WO | 2010037212 A1 | 08-04-2010 |

EPO FORM P0459

For more details about this annex : see Official Journal of the European Patent Office, No. 12/82